Europäisches Patentamt

European Patent Office

Office européen des brevets

(11) Veröffentlichungsnummer: **0 342 699**

**A2**

(12) **EUROPÄISCHE PATENTANMELDUNG**

(21) Anmeldenummer: 89109069.8

(22) Anmeldetag: 19.05.89

(51) Int. Cl.⁴: **H01L 29/78 , H01L 29/60 , H01L 31/10 , G11C 19/00**

Die Bezeichnung der Erfindung wurde geändert (Richtlinien für die Prüfung im EPA, A-III, 7.3).

(30) Priorität: 19.05.88 DE 3817153

(43) Veröffentlichungstag der Anmeldung:
23.11.89 Patentblatt 89/47

(84) Benannte Vertragsstaaten:
CH DE FR GB LI NL SE

(71) Anmelder: **Messerschmitt-Bölkow-Blohm Gesellschaft mit beschränkter Haftung Robert-Koch-Strasse D-8012 Ottobrunn(DE)**

Anmelder: **Lutz, Gerhard, Dr. Therese-Giehse-Allee 23 D-8000 München 83(DE)**

Anmelder: **Strüder, Lothar Türkenstrasse 33 D-8000 München 40(DE)**

(72) Erfinder: **Kemmer, Josef, Dr. Hauptstrasse 41d D-8041 Heimhausen(DE)**
Erfinder: **Holl, Peter Dürerstrasse 2a D-8018 Grafing(DE)**
Erfinder: **Lutz, Gerhard, Drw. Therese-Giehse-Allee 23 D-8000 München 83(DE)**
Erfinder: **Strüder, Lothar Türkenstrasse 33 D-8000 München 40(DE)**

(54) **Ladungsgekoppeltes Halbleiterbauelement.**

(57) Es ist ein ladungsgekoppeltes Halbleiterbauelement beschrieben mit Speicherung und Transfer von Ladungsträgern in mindestens einem Kanal im Volumen eines Halbleiterkörpers nahe seiner mit Gate-Elektroden versehenen Oberfläche, wobei die Führung der Ladungsträger in dem Kanal/den Kanälen durch Veränderung der Form der Gate-Elektroden in einer Richtung im wesentlichen senkrecht zur Transferrichtung erfolgt.

FIG.2

**Halbleiter-Bauelement**

Die Erfindung betrifft ein ladungsgekoppeltes Halbleiterbauelement mit Speicherung und Transfer von Ladungsträgern in mindestens einem Kanal im Volumen eines Halbleiterkörpers nahe seiner mit Gate-Elektroden versehenen Oberfläche.

Aus der Druckschrift EP 0 220 120 A1 ist ein ladungsgekoppeltes Halbleiter-Bauelement bekannt, mit Gate-Elektroden senkrecht zur Transfer-Richtung der Ladungsträger. Diese weisen verschieden breite Abschnitte auf, um die Dimensionen der Gesamtanordnung zu verkleinern.

Beim sogenannten "buried channel"-CCD und Weiterbildungen wie z.B. dem "Peristaltic"-CCD erfolgt der Transfer der Ladungen in kleinen Abständen - etwa in der Größenordnung von $1\mu m$ - von der Oberfläche; bei den voll depletierbaren p-n-CCD's (siehe L. Strüder et al in Nuclear Instr. and Meth. in Phys. Res. A 253, 1987, 386) jedoch in Abständen der gleichen Größenordnung wie die der Bildzellen (Pixel) bzw. der Schiebeelektroden. Nachteilig ist dabei eine relativ komplizierte Herstellungstechnik.

Der Erfindung liegt die Aufgabe zugrunde, die Herstellungstechnik solcher CCD's zu vereinfachen und zugleich ihre Wirkung zu verbessern.

Die erfindungsgemäße Lösung besteht bei einer CCD-Struktur gemäß Patentanspruch 1 darin, daß die Führung der Ladungsträger durch Veränderung der Form (Geometrie) der Gate-Elektroden in einer Richtung im wesentlichen quer zur Transfer-Richtung in einem Kanal erfolgt.

Dadurch wird bewirkt, daß sich das elektrische Potential im Kanal gemäß der Änderung der Form der Gate-Elektroden und ihrer Struktur ändern kann.

Eine unsymmetrische Form der Elektroden ergibt eine Vorzugsrichtung im Kanal und bewirkt, daß die Struktur als 2-Phasen-CCD betrieben werden kann. Selbstverständlich kann durch eine Kombination der Änderung der Form der Elektroden mit einer Änderung der Dotierung im Kanal auch eine verbesserte Wirkung erzielt werden.

Die Herstellungstechnologie ist wesentlich vereinfacht, soweit Dotierungsänderungen durch Änderungen der Geometrie ersetzt werden bzw. Technologieschritte wie Lithografieschritte eingespart werden. Gleichzeitig wird dabei das Problem genauer Justage/Alinierung zweier Schritte vermieden und die Fehlermöglichkeiten bei der Herstellung werden reduziert.

Die erfindungsgemäße Lösung ist vielseitig anwendbar, insbesondere für Sensoren wie Strahlungsdetektoren z.B. zur Messung der Intensität/Herkunft einfallender elektromagnetischer Strahlung - vgl. die DE-OS 34 18 778, 34 27 476, 33 30 861.

Ausführungsbeispiele der Erfindung sind in den beigefügten Zeichnungen dargestellt. Es zeigen:

Fig.1 eine übliche grundlegende Art der CCD-Topografie,

Fig.2 eine schematische Ansicht einer üblichen CCD-Geometrie,

Fig. 3a eine Draufsicht zu Fig. 3b,

Fig. 3b einen Schnitt durch die erfindungsgemäße CCD-Struktur längs der Linie A-A von Fig. 3a,

Fig. 4 eine Abwandlung der Erfindung,

Fig. 5 eine weitere Abwandlung der Erfindung.

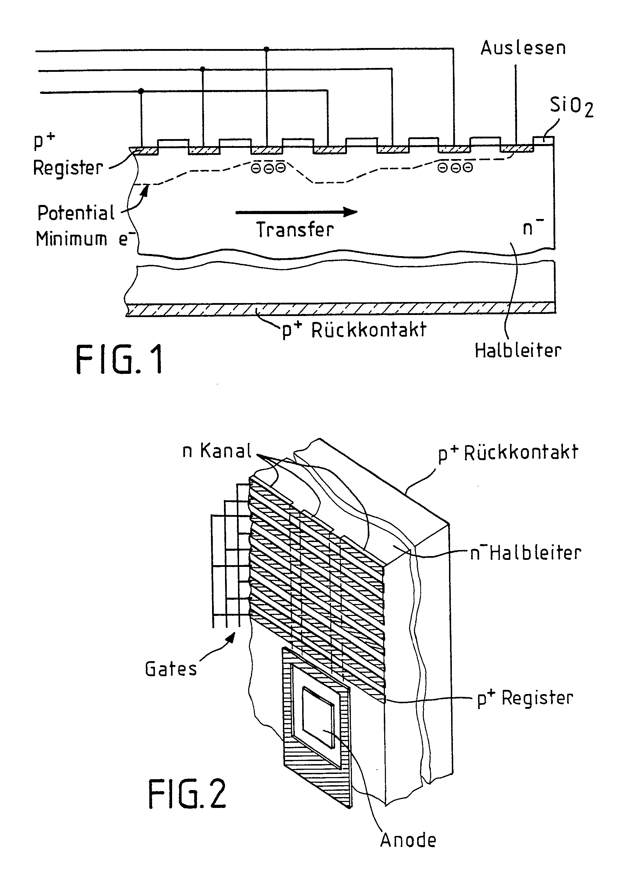

Die Erfindung geht aus von einem bekannten CCD mit Ladungstransfer im Material (bulk) des Halbleiters, wie z.B. in Fig. 1 und 2 dargestellt.

In Fig. 1 ist ersichtlich, daß das Material des Halbleiters auf einer Seite mit streifenförmigen Elektroden belegt ist an seiner mit $SiO_2$-passivierten Oberfläche. Die Elektroden dienen als Transferregister mit Transfer-Richtung nach rechts (in der Fig. 1) und Ausleseelektrode am rechten Ende.

Aus Fig. 2 ist die Implantationstechnologie und der Kanalbegrenzungsmechanismus ersichtlich. Es handelt sich dabei um einen voll depletierbaren p-n-CCD. Die dargestellte tiefe n-Implantationstechnologie bewirkt einerseits die Vermeidung der Injektion von Minoritätsträgern (Löchern) von den $p^+$-Transferregistern (gates) in den bulk, andererseits die Führung der Signalladung (Elektronen) im Kanal (n-Kanal). Die Kanalbegrenzungen werden durch Unterbrechung der tiefen n-Implantation gebildet.

Eine Verbesserung der Transfereigenschaften wird davon erwartet, daß die tiefe n-Implantation auf die Region unter den p-Streifen beschränkt bleibt und unter dem freiliegenden (Si-)Oxid vermieden wird.

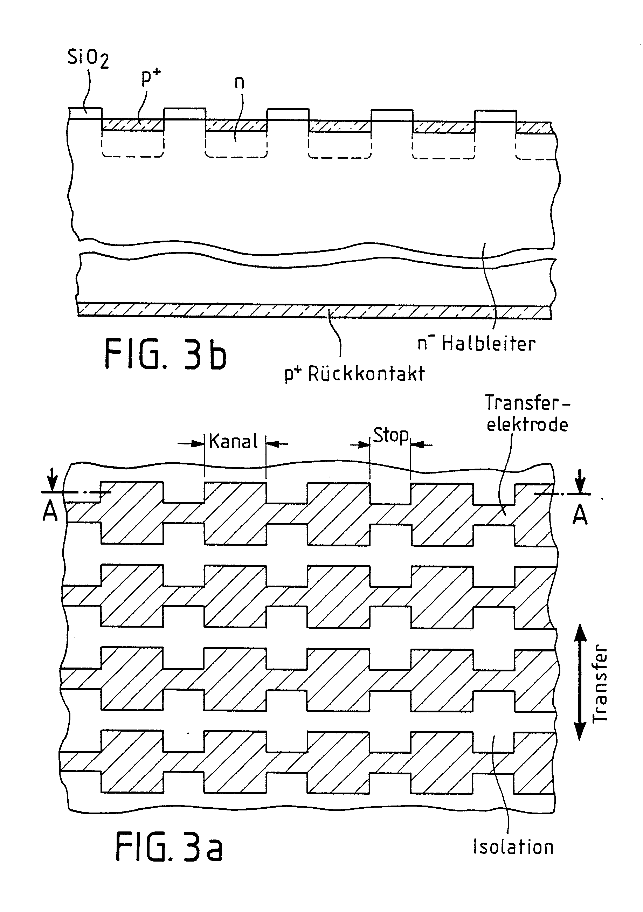

Dies bringt jedoch die - eingangs geschilderten - Probleme der Justierung der in verschiedenen Schritten erfolgenden $p^+$- und tiefen n-Implantationen. Die erfindungsgemäße Lösung dieses Problems liegt in der Ausbildung der Kanäle und deren Begrenzung durch einfache Veränderung der Geometrie, insbesondere der Breite der Transferelektroden (Fig. 3a und 3b).

Dabei kann derselbe Photolithografieschritt für $p^+$- und für tiefe n-Implantation verwendet werden. Dies bedeutet, daß jegliche Justage entfällt. Ein Beispiel einer solchen Elektrodenstruktur, die als 3-Phasen-CCD betrieben werden kann, lassen Fig. 3a und 3b erkennen. Dabei ist - wie im Stand der Technik - auf einer $p^+$-Implantation (als Rückseitenkontakt) der Halbleiterkörper z.B. aus Silizium o.ä. geeignetem Material als Basis vorhanden. Die $p^+$-Elektroden und deren Hauptoberfläche sind in diesem Beispiel identisch mit den Regionen tiefer n-Implantationen.

Die Elektrodenstruktur weist - vgl. Fig. 3a - periodische Veränderungen, hier Verengungen abwechselnd mit Verbreiterungen längs der Linie A-A auf. Dabei dienen die Verbreiterungen als Kanal und die engen Stellen als Kanalbegrenzung.

Die abwechselnden Verengungen und Verbreiterungen der Gate-Struktur haben zur Folge, daß sich bei Anlegen einer gleichen Spannung an alle $p^+$-Transferelektroden in einigem Abstand von der oberen Hauptoberfläche entsprechend wechselnde Potentialmaxima jeweils im Zentrum einer breiten Region der Transferelektroden ausbilden. Die verengten Stellen der Elektroden verhindern ein seitliches Auseinanderfließen entlang der gezeichneten Linie A-A in Fig. 3a und wirken als Kanalbegrenzung. Der Transfer der Ladungen senkrecht (quer) zur Transferelektrodenrichtung kann wie bei einem 3-Phasen-CCD durch wechselnde (periodische) Veränderungen der Potentiale an den Transferelektroden erfolgen.

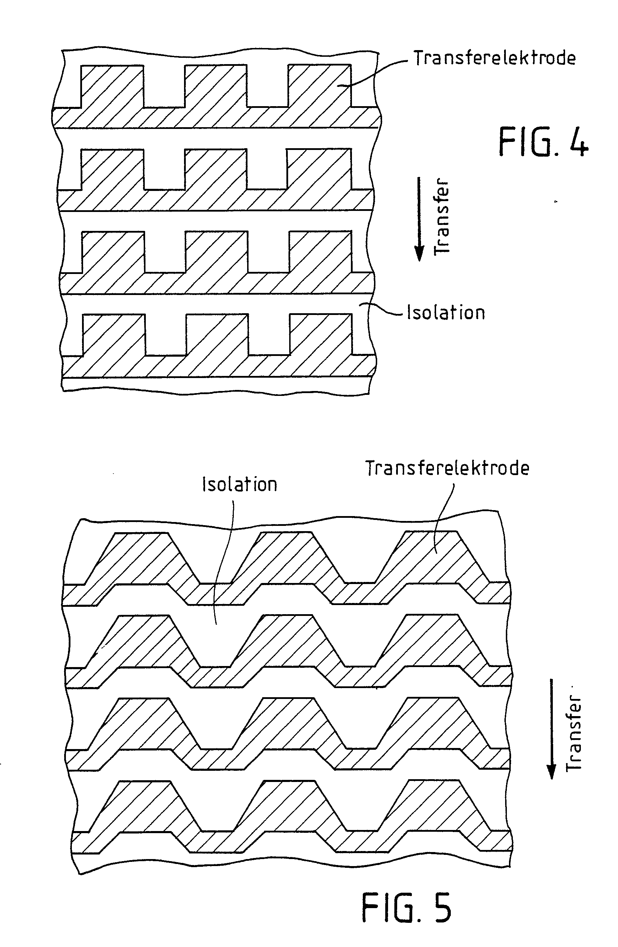

Abwandlungen des Grundgedankens der Erfindung sind in den Fig. 4 und 5 dargestellt. Dabei ist die Verbreiterung/Verengung der $p^+$- und der tiefen n-Implantation unsymmetrisch ausgeführt, bevorzugt auch periodisch gleich abwechselnd. Damit ergibt sich im Kanal eine bevorzugte Schieberichtung und diese Anordnung läßt sich als 2-Phasen-CCD betreiben. Bei der ebenfalls unsymmetrischen - jedoch anders geformten - Ausführung nach Fig. 5 ergibt sich ein verhältnismäßig schnellerer Ladungstransfer.

Weitere Abwandlungen der Ausführung, insbesondere der Elektrodenform, können selbstverständlich vorgenommen werden, ohne hierdurch das Wesen der Erfindung, wie insbesondere in den Ansprüchen gekennzeichnet, zu verlassen.

Auch Kombinationen mit Merkmalen aus dem eingangs erwähnten Stand der Technik sind möglich.


**Ansprüche**

1. Ladungsgekoppeltes Halbleiterbauelement mit Speicherung und Transfer von Ladungsträgern in mindestens einem Kanal im Volumen eines Halbleiterkörpers nahe seiner mit Gate-Elektroden versehenen Oberfläche, **dadurch gekennzeichnet,** daß die Führung der Ladungsträger in dem Kanal/den Kanälen durch Veränderung der Form der Gate-Elektroden in einer Richtung im wesentlichen senkrecht zur Transferrichtung erfolgt.

2. Ladungsgekoppeltes Halbleiterbauelement nach Anspruch 1, **dadurch gekennzeichnet,** daß durch die unsymmetrische Form der Gate-Elektroden die Bewegung der Ladungsträger in Transferrichtung eine Vorzugsrichtung aufweist, derart, daß das Halbleiterbauelement in 2-Phasen betrieben wird.

3. Ladungsgekoppeltes Halbleiterbauelement nach Anspruch 1 oder 2, **dadurch gekennzeichnet,** daß die Führung der Ladungsträger in dem Kanal/den Kanälen durch Kombination der Veränderung der Dotierung mit der Veränderung der Form der Gate-Elektroden.

4. Ladungsgekoppeltes Halbleiterbauelement nach einem der vorhergehenden Ansprüche, **dadurch gekennzeichnet,** daß ein Teil des Halbleiterkörpers aus einer epitaktisch abgeschiedenen Schicht besteht.

5. Verfahren zum Betrieb eines ladungsgekoppelten Halbleiterbauelements nach Anspruch 1, **dadurch gekennzeichnet,** daß es in 3-Phasen betrieben wird.

6. Verwendung eines ladungsgekoppelten Halbleiterbauelements nach einem der Ansprüche 1 bis 4 als Strahlungsdetektor zur Messung der Intensität und/oder Herkunft an der Oberfläche einfallender elektromagnetischer Strahlung.

FIG.1

FIG.2

10 469

FIG. 3b

$SiO_2$  $p^+$  $n$

$p^+$ Rückkontakt   $n^-$ Halbleiter

Kanal   Stop   Transfer-elektrode

A — A

Transfer

Isolation

FIG. 3a

10 469

FIG. 4

Transferelektrode

Transfer

Isolation

Isolation

Transferelektrode

Transfer

FIG. 5

10 469